(19) Europäisches Patentamt / European Patent Office / Office européen des brevets

(11) **EP 2 722 992 B1**

(12) **FASCICULE DE BREVET EUROPEEN**

(45) Date de publication et mention
de la délivrance du brevet:
**20.05.2015 Bulletin 2015/21**

(51) Int Cl.:
***H03M 13/11*** *(2006.01)*    ***H03M 13/29*** *(2006.01)*
***H03M 13/17*** *(2006.01)*    ***H03M 13/37*** *(2006.01)*

(21) Numéro de dépôt: **13188157.5**

(22) Date de dépôt: **10.10.2013**

(54) **Méthode de codage pour canal à évanouissement quasi-périodique**

Kodierungsmethode für Kanal mit quasi-periodischem Signalschwund

Coding method for channel with quasi-periodic fading

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.10.2012 FR 1260002**

(43) Date de publication de la demande:
**23.04.2014 Bulletin 2014/17**

(73) Titulaires:
• **Commissariat à l'Énergie Atomique et aux Énergies Alternatives
75015 Paris (FR)**
• **Eutelsat SA
75015 Paris (FR)**

(72) Inventeurs:
• **Savin, Valentin
38000 GRENOBLE (FR)**
• **Pham Sy, Lam
95000 CERGY (FR)**

(74) Mandataire: **Augarde, Eric et al
Brevalex
56 Boulevard de l'Embouchure,
Bât. B
B.P. 27519
31075 Toulouse Cedex 2 (FR)**

(56) Documents cités:
**US-A- 6 031 874**

• **WAI HAN FONG ET AL: "Multiple Phased-Burst Correcting Superposition Product LDPC Codes", ICC 2011 - 2011 IEEE INTERNATIONAL CONFERENCE ON COMMUNICATIONS - 5-9 JUNE 2011 - KYOTO, JAPAN, IEEE, PISCATAWAY, NJ, USA, 5 juin 2011 (2011-06-05), pages 1-5, XP031908566, DOI: 10.1109/ICC. 2011.5962812 ISBN: 978-1-61284-232-5**
• **MATUZ BALAZS ET AL: "Link Layer Coding for DVB-S2 Interactive Satellite Services to Trains", VEHICULAR TECHNOLOGY CONFERENCE, 2008. VTC SPRING 2008. IEEE, IEEE, PISCATAWAY, NJ, USA, 11 mai 2008 (2008-05-11), pages 2922-2926, XP031255768, ISBN: 978-1-4244-1644-8**
• **STEFANO CIONI ET AL: "Advanced Fade Countermeasures for DVB-S2 Systems in Railway Scenarios", EURASIP JOURNAL ON WIRELESS COMMUNICATIONS AND NETWORKING, vol. 2007, no. 1, 26 juillet 2007 (2007-07-26), page 049718, XP055056607, ISSN: 1687-1499, DOI: 10.1109/25.845114**

**Description**

**DOMAINE TECHNIQUE**

La présente invention concerne de manière générale le domaine du codage canal et plus particulièrement un codage adapté à un canal présentant des évanouissements quasi-périodiques.

**ÉTAT DE LA TECHNIQUE ANTÉRIEURE**

La plupart des systèmes de télécommunications actuels utilisent un codage canal, encore dénommé codage correcteur d'erreurs ou FEC (*Forward Error Correction*) pour protéger les données contre la corruption qu'elles peuvent subir lors de la transmission sur le canal. Parmi les types de corruption pouvant affecter les données, on distingue généralement les erreurs de transmission des effacements (*erasures*). Dans le premier cas, les données sont reçues avec des erreurs, dues par exemple à un rapport signal à bruit insuffisant sur le canal. Dans le second cas, ces données sont purement et simplement indisponibles ou inutilisables, suite par exemple à un évanouissement (*fade*) voire un évanouissement sévère (*deep fade*) du canal. On parle alors d'un canal à effacement (*erasure channel*).

Nous considérerons dans la suite le cas particulier d'un canal de transmission à évanouissement quasi-périodique. Un tel canal peut être modélisé par deux états :

- un premier état dit « mauvais », apparaissant de manière quasi-périodique et de durée quasi-constante. Pendant la durée de ce premier état, le canal est affecté d'un évanouissement et les données transmises subissent un effacement ;
- un second état dit « bon » pendant lequel le canal est simplement bruité. Le cas échéant, pendant ce second état, les données peuvent subir un effacement aléatoire et de durée brève par rapport à la durée de l'effacement du premier état.

Un exemple de canal à évanouissement quasi-périodique est constitué par le canal de transmission entre un satellite et un train ou RSC (*railroad satellite channel*) tel que décrit notamment dans l'article de G. Siascia et al. intitulé « Statistical characterization of the railroad satellite channel at Ku-band » publié dans Proceedings of the International Workshop of COST actions 272 and 280, Mai 2003. Le canal RSC présente un intérêt tout particulier dans le contexte de la seconde génération de diffusion de vidéo numérique par satellite ou DVB-S2 (*Digital Video Broadcasting via Satellite*).

Dans le cas du canal RSC mentionné ci-dessus, l'état dit « mauvais » correspond au passage sous les portiques d'accrochage de la caténaire (*power arches)* disposés à intervalles réguliers le long de la voie ferrée. En effet, lorsque l'antenne d'un terminal passe sous un tel portique le canal entre le satellite et le terminal subit généralement un évanouissement sévère.

L'état « bon » du canal RSC correspond en revanche à la situation LOS (*Line Of Sight*) où l'antenne du terminal est en ligne de visée directe du satellite. Les évanouissements brefs sont principalement dus aux interférences multitrajet (*Ricean fading).*

Afin de protéger les données transmises contre les évanouissements quasi-périodiques, plusieurs solutions ont été proposées dans la littérature.

Tout d'abord, il est possible de prévoir un code correcteur d'erreurs avec un très long entrelacement au niveau de la couche physique. Toutefois, cette solution nécessite des mémoires de très grande taille et des circuits de traitement complexes et coûteux.

Une autre solution mieux adaptée est de prévoir un codage correcteur d'erreurs au niveau de la couche liaison (paquets), comme décrit par exemple dans l'article de B. Matuz et al. intitulé « Link layer coding for DVB-S2 interactive satellite service to trains », Vehicular Technology Conference, 2008, VTC Spring 2008, pp. 2922-2926, 11-14 May 2008, voire au niveau de la couche réseau (datagrammes IP) comme décrit dans l'article de S. Cioni et al. intitulé « Advanced fade countermeasures for DVB-S2 systems in railway scenarios », EURASIP Journal on Wireless communications and networking, 2007, Vol. 2007, pages 1-17.

Le codage correcteur d'erreurs au niveau de la couche liaison ne fait toutefois pas l'économie d'un entrelacement entre la couche physique et la couche liaison, autrement dit les paquets doivent eux-mêmes être entrelacés avant d'être codés, ce qui requiert à nouveau des circuits complexes.

Le codage correcteur d'erreurs au niveau de la couche réseau requiert un procédé de segmentation et d'encapsulation complexe (GSE-FEC).

Dans les deux cas, ces techniques de codage ne permettent pas de remédier aux effacements longs du canal RSC, notamment lorsqu'un train à grande vitesse est contraint de ralentir.

Enfin, les codes correcteurs utilisés dans l'art antérieur sont des codages bloc classiques, mal adaptés à un scenario d'effacement périodique tel que celui du canal RSC. En particulier, ces codes peuvent présenter un débit (fraction du nombre de symboles d'information sur le nombre de symboles codés) faible en regard de la probabilité d'effacement.

Le but de la présente invention est par conséquent de proposer un codage correcteur d'erreurs qui remédie aux inconvénients de l'état de la technique et en particulier qui ne nécessite pas la réalisation d'un circuit complexe/de mémoire de grande taille et soit particulièrement bien adapté à un scénario d'effacement périodique.

## EXPOSÉ DE l'INVENTION

La présente invention est définie comme une méthode de codage correcteur d'erreurs pour canal à évanouissement quasi-périodique, ladite méthode codant un bloc de $K$ symboles d'information en un bloc de $N$ symboles codés, ledit évanouissement quasi-périodique se traduisant par un effacement d'au plus $m$ symboles consécutifs codés dudit bloc, ladite méthode utilisant un code $(N,K)$ défini par une matrice de contrôle de parité, $\mathbf{H}$, de taille $(N-K) \times N$, la taille $N$ du code vérifiant $N = \bar{n}m$ et $N < \rho T$ où $\bar{n}$ est un nombre entier supérieur ou égal à 2, $\rho$ est le débit de transmission des symboles codés et $T$ étant la période entre évanouissements consécutifs du canal, ladite matrice de contrôle de parité comprenant une sous-matrice, $\mathbf{H} = \left( \mathbf{T}_m^{(1)} \middle| \mathbf{T}_m^{(2)} \cdots \middle| \mathbf{T}_m^{(\bar{n})} \right)$, obtenue par concaténation horizontale de $\bar{n}$ matrices triangulaires $\mathbf{T}_m^{(n)}$, $n = 1,..., \bar{n}$ où les matrices $\mathbf{T}_m^{(n)}$, de taille $m \times m$, sont toutes triangulaires supérieures ou bien toutes triangulaires inférieures, et d'éléments diagonaux non nuls, la matrice de contrôle de parité étant définie à une permutation près de ses lignes.

Les matrices triangulaires $\mathbf{T}_m^{(n)}$, $n = 1,..., \bar{n}$ peuvent être notamment toutes identiques, par exemple se réduire à la matrice identité $\mathbf{I_m}$.

Selon un premier mode de réalisation non revendiqué ladite matrice de contrôle de parité $\mathbf{H}$ est constituée par ladite sous-matrice.

Selon un second mode de réalisation non revendiqué, la matrice de contrôle de parité est obtenue par concaténation verticale d'une matrice supérieure, constituée par ladite sous-matrice, et d'une matrice inférieure constituée par une matrice creuse de taille $l \times N$ avec $l = M - m$ où $M = N - K$.

Selon un troisième mode de réalisation, la matrice de contrôle de parité est obtenue par concaténation verticale d'une matrice supérieure, $\mathbf{H_U}$, constituée par ladite sous-matrice, et d'une matrice inférieure, $\mathbf{H_L}$, elle-même constituée par la concaténation d'une première matrice élémentaire creuse, $\mathbf{H}_L^1$, de taille $l \times K$, d'une seconde matrice élémentaire, $\mathbf{H}_L^2$, triangulaire de taille $l \times l$, d'une troisième matrice élémentaire creuse, $\mathbf{H}_L^3$, de taille $l \times (m-l)$, et d'une quatrième matrice élémentaire, $\mathbf{H}_L^4$, triangulaire de taille $l \times l$ et de diagonale nulle, les matrices $\mathbf{H}_L^2$ et $\mathbf{H}_L^4$ étant de même nature, inférieure ou supérieure, que les matrices triangulaires $\mathbf{T}_m^{(n)}$, $n = 1,..., \bar{n}$.

Selon une première variante du troisième mode de réalisation, la matrice de contrôle de parité est obtenue par concaténation verticale d'une matrice supérieure, $\mathbf{H_U}$, constituée par ladite sous-matrice, et d'une matrice inférieure, $\mathbf{H_L}$, elle-même constituée par la concaténation d'une première matrice élémentaire creuse, $\mathbf{H}_L^1$, de taille $l \times K$, d'une seconde matrice élémentaire, $\mathbf{H}_L^2$, égale à une matrice triangulaire inférieure $\mathbf{T}_l$, de taille $l \times l$, d'une troisième matrice élémentaire creuse, $\mathbf{H}_L^3$, de taille $l \times (m-l)$, et d'une quatrième matrice élémentaire, $\mathbf{H}_L^4$, de taille $l \times l$, n'ayant des éléments non nuls qu'au dessous de sa diagonale.

Selon une seconde variante du troisième mode de réalisation, la matrice de contrôle de parité est obtenue par concaténation verticale d'une matrice supérieure, $\mathbf{H_U}$, constituée par ladite sous-matrice, et d'une matrice inférieure, $\mathbf{H_L}$, elle-même constituée par la concaténation d'une première matrice élémentaire creuse, $\mathbf{H}_L^1$, de taille $l \times K$, d'une seconde matrice élémentaire, $\mathbf{H}_L^2$, égale à une matrice triangulaire supérieure $\mathbf{T}_l$ de taille $l \times l$, d'une troisième matrice élémentaire creuse, $\mathbf{H}_L^3$, de taille $l \times (m-l)$, et d'une quatrième matrice élémentaire, $\mathbf{H}_L^4$, de taille $l \times l$, n'ayant des éléments non nuls qu'au dessus de sa diagonale.

La méthode de codage peut s'appliquer à la couche physique, lesdits symboles étant alors des bits.

Toutefois, de préférence, elle s'appliquera à la couche liaison, lesdits symboles d'information étant alors des paquets de données de la couche physique. De manière plus générale, elle pourra s'appliquer à une couche de niveau $n > 2$ dans le protocole OSI, lesdits symboles d'informations étant des paquets formés par des données de la couche $n$ -1.

## BRÈVE DESCRIPTION DES DESSINS

La Fig. 1 illustre un contexte d'application de la méthode de codage correcteur d'erreurs utile pour comprendre la présente invention ;

La Fig. 2A représente la structure d'une première matrice de contrôle de parité utilisée par la méthode de codage selon un premier mode de réalisation qui ne fait pas partie de l'invention ;

La Fig. 2B représente la structure d'une première matrice de contrôle de parité utilisée par la méthode de codage selon une version plus générale du premier mode réalisation qui ne fait pas partie de l'invention ;

La Fig. 3 représente la structure d'une seconde matrice de contrôle de parité utilisée par la méthode de codage selon un second mode de qui ne fait pas partie de l'invention ;

La Fig. 4 représente la structure d'une troisième matrice de contrôle de parité utilisée par la méthode de codage selon un troisième mode de réalisation, celui-ci correspondant à l'invention ;

La Fig. 5 illustre de manière schématique les différentes étapes de calcul des symboles de parité sur la matrice de la Fig. 4 ;

Les Figs. 6A et 6B représentent le taux d'erreur symbole au niveau de la couche liaison lorsque la méthode de codage est mise en oeuvre dans le cadre d'une transmission sur canal RSC, pour deux vitesses de train respectivement.

## EXPOSÉ DÉTAILLÉ DE MODES DE RÉALISATION PARTICULIERS

Nous considérerons dans la suite un canal à évanouissement quasi-périodique au sens défini plus haut, tel que par exemple le canal RSC présenté plus haut.

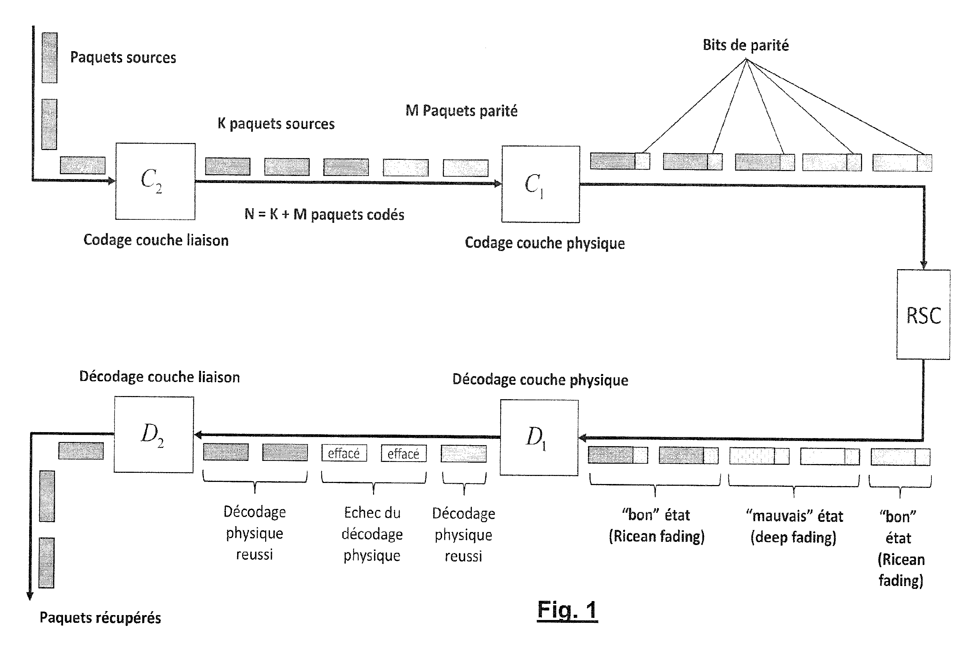

La Fig. 1 représente un contexte d'application de la présente invention.

Les symboles d'information (bits par exemple) à transmettre sont regroupés sous forme de paquets, dit paquets source, issus d'une couche applicative. Dans le cas d'une diffusion DVB-S2, par exemple, ces paquets sont des paquets MPEG-TS (MPEG transport stream).

Ces paquets font de préférence l'objet d'un codage correcteur d'erreurs au niveau de la couche liaison (2nde couche du modèle OSI) dans le codeur $C_2$. Plus précisément, le codeur $C_1$ code une pluralité $K$ de paquets incidents $P_1...,P_K$ en tant que paquets source en une pluralité $N > K$ de paquets codés. Lorsque le codage est systématique, cette pluralité de paquets codés est constituée des paquets source $P_1,...,P_K,,,$ suivis de $M = N - K$ paquets de parité $P_{K+1},...,P_N$ (de même taille que les paquets source) représentant la redondance du code. Un paquet de parité est obtenu comme une somme, bit à bit, de plusieurs paquets source, formalisée par un contrôle de parité.

Les paquets $P_1,....,P_N$ peuvent subir ensuite un second codage correcteur d'erreurs au niveau de la couche physique (1ère couche du modèle OSI) dans le codeur $C_1$. Plus précisément, chaque paquet $P_k$, $k = 1,..,K$, de taille $q$ ($q$ bits) est alors codé en un paquet $P'_k$ de taille $q'>q$. Là encore, si le codage est systématique, le paquet $P'_k$ sera constitué des $q$ bits initiaux et de $q'-q$ bits de parité représentant la redondance du code. Il est également possible de regrouper plusieurs paquets $P_i,...,P_j$ en un super-paquet, $P_{i-j}$ et d'appliquer le codage correcteur d'erreurs à ce super-paquet. On obtient alors un nouveau paquet, $P'_{i-j}$ qui, dans le cas d'un code systématique, contient les bits du super-paquet, c'est-à-dire de l'ensemble des paquets initiaux, $P_i,...,P_j$, ainsi que les bits de parité correspondant à la redondance du code.

Le cas échéant, un entrelacement (non représenté) peut être prévu au niveau paquet avant le codeur $C_2$ et, au sein de chaque paquet (ou super-paquet) avant le codeur $C_1$.

Dans tous les cas, après transmission sur le canal à évanouissement périodique, les paquets $P'_k$ ainsi codés sont traités par le récepteur comme indiqué ci-après.

Au niveau de la couche physique, chacun des paquets $P'_k$ est décodé par le décodeur $D_1$. Si le décodage est réussi, le paquet $P_k$ est transmis à la couche liaison. En revanche, si le décodage échoue (par exemple, lorsque le canal subit un évanouissement) le paquet $P_k$ ne peut pas être récupéré et est considéré comme effacé. L'information de paquet effacé est alors transmise à la couche liaison.

Au niveau de la couche liaison, chacun des paquets $P_k$ est, soit correctement reçu, soit considéré comme effacé. Le décodeur $D_2$ effectue alors un décodage de la séquence de paquets $P_1,..., P_N$ dans laquelle un ou plusieurs paquets peuvent être effacés, pour récupérer les paquets initiaux $P_1,...,P_K$.

On parlera plus spécifiquement de canal à effacement quasi périodique lorsque, au niveau de la couche liaison (ou d'une couche supérieure), les paquets de cette couche sont périodiquement effacés en raison des évanouissements périodiques intervenant au niveau de la couche physique sous-jacente. Le terme canal à effacement périodique sera donc compris par conséquent comme cas particulier d'un canal à évanouissement périodique.

La méthode codage selon la présente invention est de préférence mise en oeuvre par le codeur $C_2$ et s'applique alors aux paquets précités.

Alternativement, la méthode de codage selon la présente invention peut être mise en oeuvre par le codeur $C_1$ et s'applique alors aux données de la couche physique (le cas échéant après entrelacement).

Dans la suite, pour conserver une présentation unitaire, nous désignerons par symboles d'information soit des données de la couche physique (bits par exemple) soit des paquets de telles données issus de la couche liaison (voire d'une couche supérieure). Dans tous les cas, le bloc des symboles d'information est noté $s_1,..,s_K$ et le bloc des symboles encodés est noté $c_1,..,c_N$. On comprend que selon le niveau envisagé (physique, liaison ou supérieur) les symboles encodés soient eux-mêmes des données de la couche physique ou des paquets de la couche liaison (ou de la couche supérieure).

On comprendra toutefois que, lorsque la présente invention est mise en oeuvre au niveau de la couche liaison, le décodage a simplement à corriger des effacements de symboles (paquets). On parle alors d'un décodage à effacements. En effet, l'entrée du décodeur est constituée par les paquets correctement décodés au niveau de la couche physique. Le fait que les paquets ont été correctement décodés peut être vérifié per exemple en utilisant un code CRC. Les autres paquets (dont le décodage a échoué) sont considérés comme étant effacés.

Lorsque la méthode de codage est mise en oeuvre au niveau de la couche physique, le récepteur utilisera un décodage d'erreurs classique. L'entrée d'un tel décodeur est constituée des rapports de vraisemblance logarithmique (LLRs), calculés à partir du signal observé en sortie du canal. Lorsque le canal passe par une étape d'évanouissement, ces LLRs ont des valeurs très proches de zéro et peuvent être considérées comme des effacements, une LLR égale à zéro signifiant que l'on ne dispose d'aucune information sur la valeur du bit correspondant.

Quel que soit le niveau d'implémentation de la méthode de codage, la taille $N$ du code est choisie de manière à ce qu'au plus un évanouissement périodique (ou état mauvais) du canal intervienne pendant la transmission d'un bloc des $N$ symboles codés $c_1,..,c_N$. En d'autres termes, si l'on note $T$ la période de récurrence du premier état (état mauvais) du canal, et $p$ le débit des symboles codés, la taille $N$ sera choisie telle que $N < \rho T$.

On note en outre $\tau$ la durée maximale de l'évanouissement du canal, ou de manière équivalente la durée maximale du premier état. Le nombre maximum de symboles effacés, pendant la durée de cet évanouissement, est donc $m = \rho\tau$.

La taille $N$ est choisie comme un multiple de $m$, $N = \bar{n}m$ où $\bar{n}$ est un nombre entier supérieur ou égal à 2, et vérifiant $N < \rho T$.

La méthode de codage selon l'invention utilise un code par bloc $(N,K)$ qui peut être classiquement défini par sa matrice génératrice (*generator matrix*) **G** de taille $K \times N$ ou par sa matrice de contrôle de parité (*parity check matrix*) **H** de taille $(N-K) \times N$.

On rappelle que si **s**=$(s_1,..,s_K)$ est le vecteur constitué par les symboles d'information, le mot de code **c** associé est donné par le vecteur :

$$\mathbf{c} = \mathbf{s}\mathbf{G} \tag{1}$$

Les mots c du code $(N,K)$ vérifient :

$$\mathbf{c}\mathbf{H}^{\mathrm{T}} = \mathbf{0} \tag{2}$$

où $.^T$ signifie la transposition matricielle, les matrices génératrice et de contrôle de parité étant liées par la relation :

$$\mathbf{G}\mathbf{H}^{\mathrm{T}} = \mathbf{0} \tag{3}$$

En outre, si le code est systématique, sa matrice génératrice présente la forme :

$$\mathbf{G} = \left(\mathbf{I}_{\mathrm{K}} \middle| \mathbf{P}\right) \tag{4}$$

où $\mathbf{I_K}$ est la matrice identité de taille $K \times K$ et P est la matrice de parité de taille $K \times (N\text{-}K)$. Dans ce cas, la matrice de contrôle de parité s'exprime comme :

$$\mathbf{H} = \left( \mathbf{P}^{\mathrm{T}} \Big| \mathbf{I}_{\mathrm{N\text{-}K}} \right) \hspace{4cm} (5)$$

où $\mathbf{I_{N\text{-}K}}$ est la matrice identité de taille $(N\text{-}K) \times (N\text{-}K)$.

Selon un premier mode de réalisation qui ne fait pas partie de l'invention, on considère que le second état du canal (état bon) n'introduit pas d'erreurs (couche physique) ou d'effacements (couche physique ou couche liaison) dans les symboles d'information. Cette situation intervient notamment lorsque la méthode de codage s'applique à la couche liaison (les symboles d'informations sont alors des paquets) et lorsque le codage correcteur d'erreurs ($C_1$) au niveau de la couche physique est suffisamment efficace pour corriger les erreurs/ effacements se produisant dans le second état du canal.

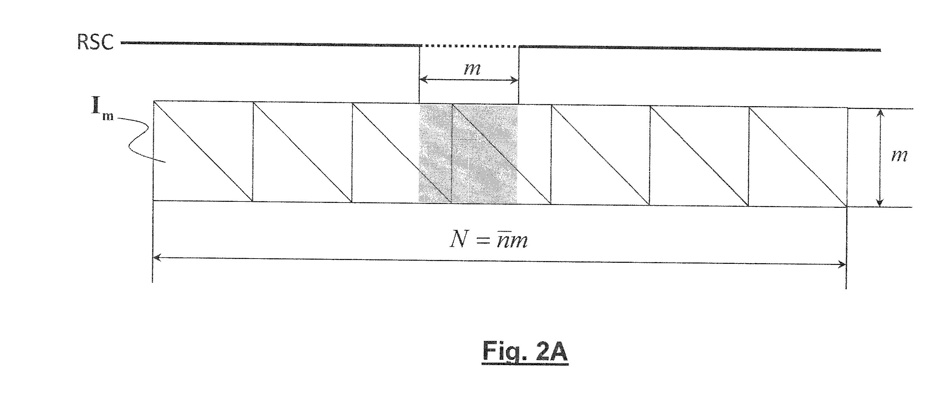

La Fig. 2A représente de manière schématique la structure d'une matrice de contrôle de parité utilisée par la méthode de codage selon le premier mode de réalisation qui ne fait pas partie de l'invention.

On note que cette matrice est constituée par la concaténation de $\bar{n}=N/m$ matrices identité $\mathbf{I_m}$ de taille $m \times m$, soit:

$$\mathbf{H} = \left( \mathbf{I_m} \Big| \mathbf{I_m} ... \Big| \mathbf{I_m} \right) \hspace{4cm} (6)$$

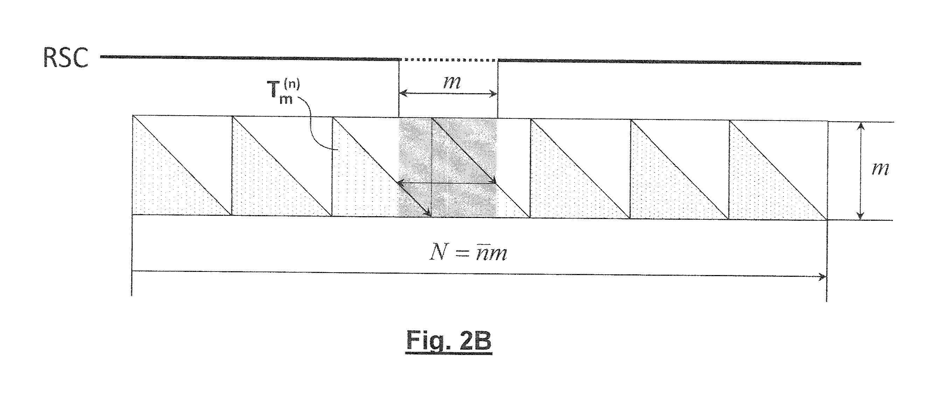

Le code est ici systématique avec $N\text{-}m$ symboles d'information et $m$ symboles de parité puisque la matrice de parité présente la forme de l'expression (5). On supposera que les $m$ symboles de parité correspondent à la dernière matrice $\mathbf{I_m}$ (la plus à droite sur la Fig. 2).

Chaque ligne de la matrice de contrôle de parité correspond à un contrôle et fait intervenir $\bar{n}$ symboles ($\bar{n}$ - 1 symboles d'information et un symbole de parité), le contrôle étant exprimé comme une somme XOR de ces $\bar{n}$ symboles. Etant donné la structure particulière de la matrice de contrôle de parité, les différents symboles intervenant dans un contrôle $i$ (ligne $i$) occupent les positions $i, i + m, i + 2m,.., i+(\bar{n}$ -1)$m$ dans le mot de code (c'est-à-dire les colonnes ayant ces indices dans la matrice $\mathbf{H}$).

Lorsqu'un effacement de longueur $m$ (symbolisé par un trait en pointillés au-dessus de la matrice) intervient, il n'affecte au plus que $m$ symboles consécutifs du mot de code. Ainsi, pour un contrôle de parité donné, $i$, l'effacement affectera au plus qu'un symbole (en position $j$ dans le mot de code) puisque les symboles précédents éventuels (en positions $j$ - $m$, $j$ - $2m$,..) et les symboles suivants éventuels (en positions $j+m$, $j+2m$,..) intervenant dans ce contrôle sont situés en dehors de la zone d'effacement. Il est donc toujours possible de restituer le symbole effacé à l'aide du contrôle en question.

Selon une version plus générale représentée en Fig. 2B, chaque matrice identité $\mathbf{I_m}$ apparaissant dans (6) peut être remplacée par une matrice triangulaire (inférieure ou supérieure), de taille $m$ x m soit :

$$\mathbf{H} = \left( \mathbf{T_m^{(1)}} \Big| \mathbf{T_m^{(2)}} ... \Big| \mathbf{T_m^{(\bar{n})}} \right) \hspace{4cm} (7)$$

où les matrices $\mathbf{T_m^{(n)}}$, $n = 1,...,\bar{n}$ sont des matrices triangulaires (toutes inférieures ou bien toutes supérieures) dont les éléments diagonaux sont non nuls, autrement dit égaux à 1. On rappelle qu'une matrice triangulaire supérieure est une matrice dont les éléments situés au-dessous la diagonale sont tous nuls et qu'une matrice triangulaire inférieure est une matrice dont les éléments situés au-dessus de la diagonale sont tous nuls.

Selon cette version, la matrice de parité apparait comme une concaténation horizontale de matrices toutes triangulaires supérieures ou bien toutes triangulaires inférieures, et dont les éléments diagonaux sont non nuls. On comprendra que cette version est plus générale que la version précédente dans la mesure où la matrice identité peut être considérée comme un cas particulier de matrice $\mathbf{T_m^{(n)}}$.

Dans un exemple particulier de réalisation les matrices triangulaires $\mathbf{T_m^{(n)}}$, $n = 1,...,\bar{n}$ peuvent être toutes identiques, c'est-à-dire : $\mathbf{T_m^{(n)}} = \mathbf{T_m}$, $\forall n$.

Il est encore possible avec la structure de matrice de parité donnée par l'expression (7) de restituer les symboles effacés, grâce aux contrôle de parité, en commençant par la première ligne contenant un symbole effacé et en poursuivant par lignes d'indices croissants, si la matrice triangulaire est inférieure, ou bien en commençant par la dernière ligne contenant un symbole effacé et en poursuivant par lignes d'indices décroissants, si la matrice triangulaire est supérieure. En effet, en procédant ainsi, chaque nouvelle ligne dans le sens indiqué par les flèches, ne contient qu'un symbole (effacé) inconnu, puisque les autres symboles sont situés, soit dans la zone d'effacement mais ont déjà été restitués au moyen d'un contrôle de parité précédent (ligne précédente), soit en dehors de la zone d'effacement.

La première variante (matrice de parité donnée par l'expression (6)) sera privilégiée lorsque la méthode de codage est mise en oeuvre au niveau de la couche liaison (voire d'une couche supérieure), alors que la deuxième variante (matrice de parité donnée par l'expression (7)) sera privilégiée lorsque la méthode de codage est mise en oeuvre au niveau de la couche physique.

En effet, dans le premier cas, les paquets dans la zone d'effacement sont purement et simplement absents (le contrôle de CRC au niveau de la couche physique les ayant déclarés comme erronés), il est donc inutile d'envisager un contrôle de parité complexe. En revanche, dans le second cas, certains bits de la zone d'effacement (état mauvais du canal) peuvent contenir une information utile (LLR non nul).

Enfin, on comprendra qu'une permutation quelconque des lignes de la matrice de contrôle de parité (7) conserve la propriété précédente, une telle permutation ne correspondant qu'à un changement de l'ordre des contrôles de parité. Autrement dit, la matrice de contrôle de parité du code pourra plus généralement résulter de la concaténation (horizontale) de $\bar{n}$ matrices $\mathbf{Q_m T_m^{(n)}}$, où $\mathbf{Q_m}$ est une matrice de permutation de taille $m \times m$ et où $\mathbf{T_m^{(n)}}$ a la même définition que précédemment.

$$H = \left( \mathbf{Q_m T_m^{(1)}} \middle| \mathbf{Q_m T_m^{(2)}} \cdots \middle| \mathbf{Q_m T_m^{(\bar{n})}} \right) \qquad (8)$$

Selon un second mode de réalisation qui ne fait pas partie de l'invention, on considère que des erreurs et/ou des effacements de brève durée peuvent intervenir sur le canal lorsque celui-ci est dans son second état (état bon).

Ainsi un mot de code peut être affecté soit d'un effacement long (d'au plus $m$ symboles) lorsque le canal est dans son premier état lors de la transmission du mot, soit d'un effacement bref et/ou d'erreurs si le canal est dans son second état lors de cette transmission.

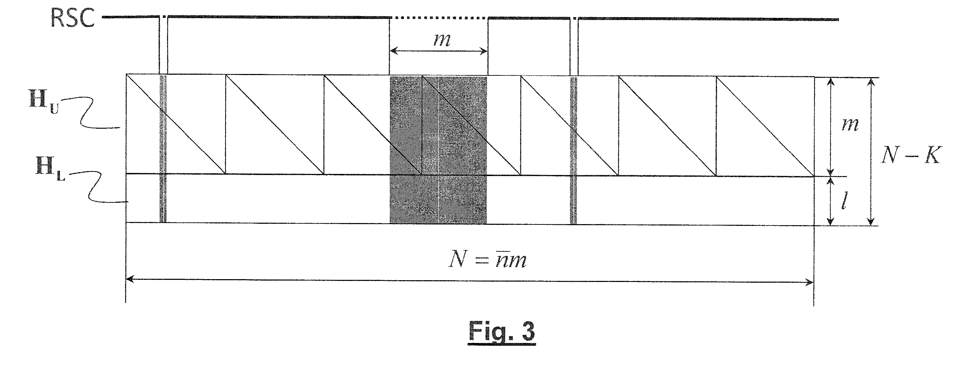

La Fig. 3 représente de manière schématique la structure d'une matrice de contrôle de parité utilisée par la méthode de codage selon le second mode de réalisation.

On note que la matrice de contrôle de parité du code $(N,K)$ de la Fig. 3 est constituée par la concaténation (verticale) d'une matrice supérieure $\mathbf{H_U}$ de taille $m \times N$ et d'une matrice inférieure $\mathbf{H_L}$ de taille $l \times N$ avec $l = M - m$ où $M$ est le nombre de contrôles de parité.

La matrice supérieure $\mathbf{H_U}$ est identique à la matrice $\mathbf{H}$ du premier mode de réalisation. Par exemple, la matrice $\mathbf{H_U}$ peut être constituée de la concaténation (horizontale) de $\bar{n}$ matrices identité $\mathbf{I_m}$ ou de $\bar{n}$ matrices $\mathbf{Q_m T_m^{(n)}}$.

La matrice $\mathbf{H_L}$ est une matrice creuse (*sparse matrix*), autrement dit une matrice ayant pour éléments des valeurs 0 et quelques valeurs 1.

On a représenté en Fig. 3 (traits pointillés) des effacements intervenus lors de la transmission du code sur le canal, à savoir un effacement long lorsque le canal était dans son premier état et quelques effacements brefs (*Rice fading*) lorsque le canal était dans son second état.

La matrice supérieure $\mathbf{H_U}$ a pour fonction de permettre la restitution des symboles effacés lors d'un effacement long (premier état). La matrice inférieure $\mathbf{H_L}$ a pour fonction de restituer les symboles effacés lors des effacements brefs et/ou de corriger des erreurs du canal dans le second état.

On comprendra que, comme dans le premier mode de réalisation, la matrice de contrôle de parité est définie à une permutation près de ses $M = N - K$ lignes.

La matrice de contrôle parité $\mathbf{H}$ représentée en Fig. 3 ne correspond toutefois pas à un code systématique. Lorsqu'un codage systématique est souhaité, on mettra avantageusement en oeuvre la méthode de codage décrite ci-après.

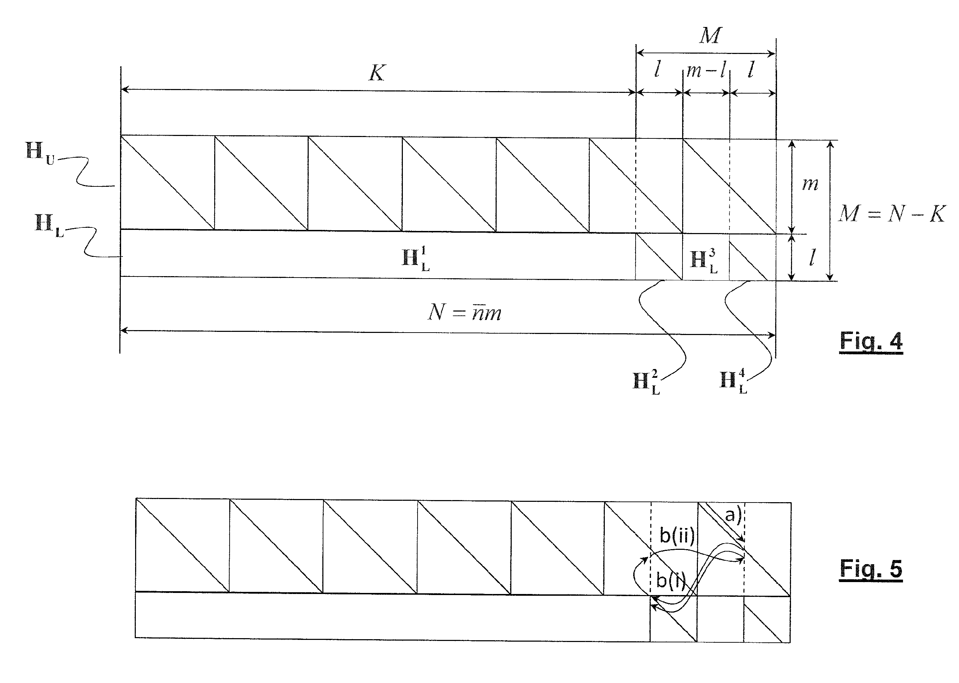

La Fig. 4 représente de manière schématique la structure d'une matrice de contrôle de parité d'un code utilisé par la méthode de codage selon un troisième mode de réalisation, celui-ci correspondant à l'invention.

On note que la matrice de contrôle de parité $\mathbf{H}$ du code $(N,K)$ de la Fig. 4 est constituée par la concaténation (verticale) d'une première matrice supérieure $\mathbf{H_U}$ de taille $m \times N$ et d'une matrice inférieure $\mathbf{H_L}$ de taille $l \times N$ avec $l = M - m$ où $M = N - K$ est le nombre de contrôles de parité.

La matrice supérieure $\mathbf{H_U}$ est constituée ici de la concaténation (horizontale) de $\bar{n}$ matrices identité $\mathbf{I_m}$ de taille $m \times m$.

La matrice inférieure $\mathbf{H_L}$ de taille $l \times N$ est constituée de la concaténation (horizontale) de quatre matrices élémentaires, représentées de gauche à droite sur la Fig. 4 :

- une première matrice élémentaire creuse (*sparse matrix*) $\mathbf{H}_L^1$ de taille $l{\times}K$ ;

- une seconde matrice élémentaire $\mathbf{H}_L^2$ égale à la matrice identité $\mathbf{I}_l$ de taille $l{\times}l$ ;

- une troisième matrice élémentaire creuse (*sparse matrix*) $\mathbf{H}_L^3$ de taille $l{\times}(m\text{-}l)$ ;

- une quatrième matrice élémentaire $\mathbf{H}_L^4$ , sous diagonale, de taille $l{\times}l$. On appelle matrice sous-diagonale une matrice dont seuls les éléments de la sous-diagonale sont non nuls (en l'occurrence ici égaux à 1).

Les *M* dernières colonnes (à droite sur la Fig. 4) correspondent aux symboles de parité. Ces *M* symboles de parité peuvent se diviser en trois groupes, notés $p_1$, $p_2$, $p_3$ de tailles respectives *l*, *m - l*, *l*.

Le code (*N,K*) est systématique puisque les *K* symboles d'information, $s_1,...,s_K$, sont transmis tels quels, les *M* = *N - K* symboles de parité étant calculés comme suit :

a) les *m - l* symboles de parité du groupe $p_2$ sont tout d'abord calculés à partir (somme XOR) des symboles d'information intervenant dans les *m - l* premières lignes de la matrice de contrôle de parité. Plus précisément, pour le contrôle *i*, le $(l{+}i)^{\text{ième}}$ symbole de parité $c_{K+l+i}$, appartenant au groupe $p_2$, est obtenu par la somme des $\overline{n}$ symboles d'information : $c_{K+l+i} = s_i \oplus s_{i+m} \oplus ... \oplus s_{i+(\overline{n}-1)m}$;

b) les symboles de parité des groupes $p_1$ et $p_3$ sont ensuite déterminés récursivement:

   i) le premier symbole de parité $c_{K+1}$, appartenant au groupe $p_1$ (le premier de ce groupe à partir de la gauche sur la Fig. 4), est calculé comme somme XOR des symboles d'information apparaissant dans la première ligne de la matrice $\mathbf{H}_L^1$ et des symboles de parité apparaissant dans la première ligne de la matrice $\mathbf{H}_L^3$ . En effet, ces symboles de parité appartiennent au groupe $p_2$ et ont été déjà calculés à l'étape (a). Il convient de noter que du fait de la sous diagonalité de la matrice $\mathbf{H}_L^4$ , les symboles de parité du groupe $p_3$ n'interviennent pas ;

   ii) le symbole de parité $c_{K+m+1}$ appartenant au groupe $p_3$ (le premier de ce groupe à partir de la gauche sur la Fig. 4) est déterminé à partir des $\overline{n}$-1 symboles d'information intervenant dans la ligne *m-l*+1 de **H** et du premier symbole de parité obtenu à l'étape précédente à savoir :

$$c_{K+m+1} = s_{m-l+1} \oplus s_{2m-l+1} \oplus \cdots \oplus s_{(\overline{n}-1)m-l+1} \oplus c_1$$

On retourne à l'étape (i) en estimant le second symbole de parité $c_{K+2}$, appartenant au groupe $p_1$, comme somme XOR des symboles d'information apparaissant dans la seconde ligne de la matrice $\mathbf{H}_L^1$ et des symboles de parité apparaissant dans la seconde ligne de la matrice $\mathbf{H}_L^3$ et du symbole de parité $c_{K+m+1}$ qui vient d'être calculé.

La Fig. 5 illustre de manière schématique les différentes étapes de calcul (a), (b)(i), (b)(ii) des symboles de parité lors du codage des symboles de parité.

De la même façon, le décodage est relativement simple puisque l'on peut toujours se ramener à la restitution d'un effacement/correction d'une erreur par ligne de contrôle. Ainsi, la complexité du décodage est linéaire en fonction de la taille *N* du code.

Selon une variante (non représentée) du troisième mode de réalisation, on peut utiliser un code (*N,K*) défini par la matrice de contrôle de parité **H** constituée par la concaténation (verticale) d'une matrice supérieure **H**$_\mathbf{U}$ de taille $m{\times}N$ et d'une matrice inférieure **H**$_\mathbf{L}$ de taille $l{\times}N$, la matrice supérieure **H**$_\mathbf{U}$ étant obtenue par concaténation horizontale de $\overline{n}$ matrices $\mathbf{Q}_m \mathbf{T}_m^{(n)}$ comme dans l'expression (8), **Q**$_\mathbf{m}$ étant une matrice de permutation et les matrices $\mathbf{T}_m^{(n)}$ étant des matrices triangulaires (toutes inférieures ou bien toutes supérieures, et d'éléments diagonaux non nuls), la matrice inférieure **H**$_\mathbf{L}$ étant constituée par la concaténation horizontale de quatre matrices élémentaires, $\mathbf{H}_L^1$ , $\mathbf{H}_L^2$ , $\mathbf{H}_L^3$ , $\mathbf{H}_L^4$ , les première et troisième matrices élémentaires $\mathbf{H}_L^1$ et $\mathbf{H}_L^3$ étant identiques à celles décrites précédemment, la seconde matrice élémentaire $\mathbb{H}_{\mathrm{L}}^{2}$ étant triangulaire et de même nature que $\mathbf{T_m}$ (inférieure ou supérieure) et la quatrième matrice élémentaire $\mathbb{H}_{\mathrm{L}}^{4}$ n'ayant des éléments non nuls qu'au-dessous ou qu'au dessus de sa diagonale (et donc des éléments nuls sur sa diagonale), selon que $\mathbf{T_m}$ est triangulaire inférieure ou supérieure.

Il est encore possible, selon cette variante, de calculer d'abord les symboles de parité du groupe $p_2$, puis par itération successives ceux des groupes $p_1$ et $p_3$.

Comme dans les modes de réalisation précédents, la matrice du code de parité est définie à une permutation près de ses lignes, une permutation des lignes équivalant à une permutation des contrôles de parité.

Quel que soit le mode de réalisation envisagé, le code $(N,K)$ défini par les matrices de parité données ci-dessus est bien adapté au canal à effacement périodique et présente une redondance minimale.

Lorsque la méthode de codage de l'invention est appliquée au niveau liaison, un entrelacement préalable des paquets n'est pas nécessaire, et la latence n'est pas affectée, ce qui est particulièrement important pour des services en mode streaming.

Il en résulte aussi que le circuit de codage correspondant ne requiert pas d'importantes ressources en mémoire.

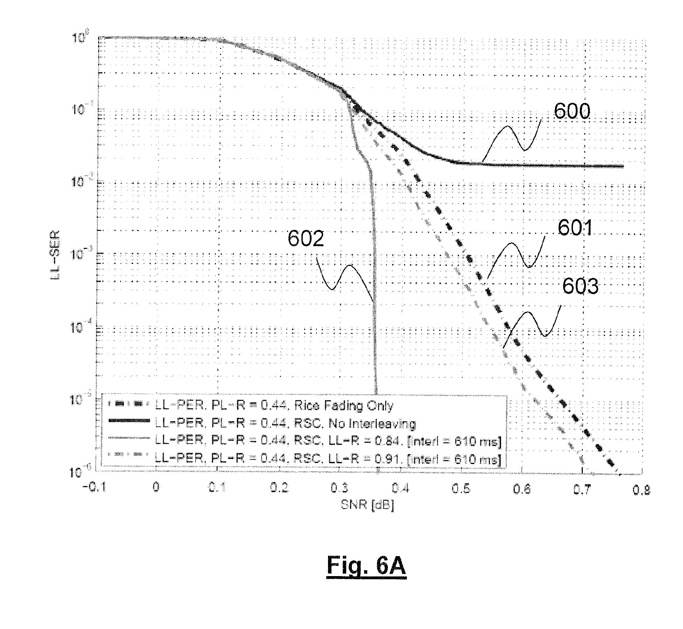

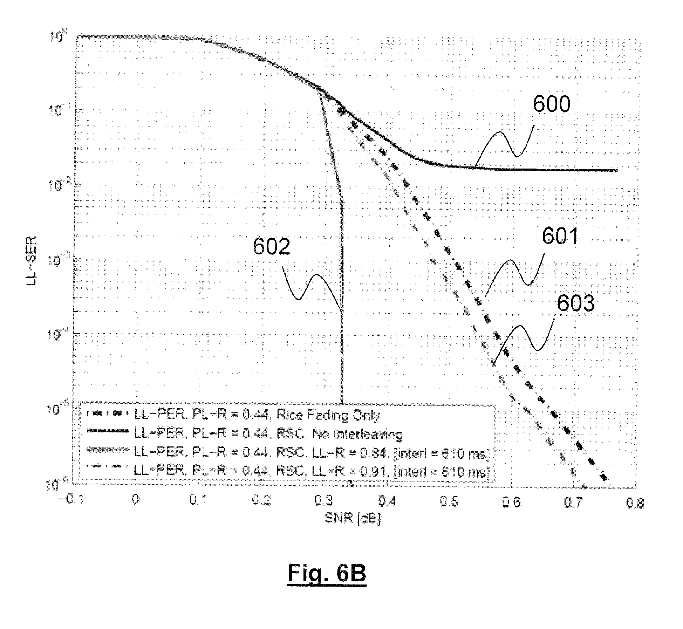

Les Figs. 6A et 6B représentent le taux d'erreur symbole au niveau de la couche liaison, autrement dit le taux d'erreurs paquet lorsque la méthode de codage est mise en oeuvre dans le cadre d'une transmission sur canal RSC.

La distance entre les portiques d'alimentation, dont dépend la période de l'effacement du canal RSC dans le premier état a été prise égale à 50m. La largeur du portique dans l'axe de déplacement du train, dont dépend la durée de l'effacement périodique, a été prise égale à 87 cm. La probabilité qu'un symbole subisse un effacement au niveau de la couche physique (en raison d'un évanouissement sévère) n'est autre que le rapport entre la largeur du portique et la distance entre portiques, à savoir $1.54\ 10^{-2}$.

On suppose que la communication entre le satellite et le terminal obéit au standard DVB-S2 avec une modulation QPSK, une vitesse de modulation de 27,5 Mbaud, un code FEC (au niveau de la couche physique) de longueur 16200 bits et de rendement 4/9.

Dans les exemples illustrés, la méthode de codage selon la présente invention a été appliquée au niveau de la couche liaison, les symboles d'information étant des paquets MPEG-TS de 188 octets. Les dimensions du code étaient $N$ = 9064; $m$ = 824; $I$ = 626 (et donc $M$ =1450).

Les Figs. 6A et 6B correspondent à une vitesse du train de 60 km/h et de 300 km/h, respectivement.

Dans les deux figures, la courbe solide en trait continu 600 représente le taux d'erreur paquet en fonction du rapport signal sur bruit (SNR) du canal RSC (évanouissement périodique sévère et évanouissement aléatoire de type Rice). La courbe en trait discontinu 601 représente le taux d'erreur paquet en l'absence d'évanouissements périodiques (évanouissement aléatoire de type Rice seulement, c'est-à-dire canal constamment dans le second état).

La courbe 603 représente le taux d'erreur paquet sur le canal RSC après le codage selon le premier mode de réalisation, donc avec un rendement de $(N-m)/N$ = 0.91.

On remarque que l'application de la méthode de codage permet d'éliminer complètement la détérioration du taux d'erreur paquet (plus précisément de supprimer le plancher du taux d'erreur paquet) due à l'effacement périodique (même à vitesse faible, cf. Fig. 6A) puisque, dans les deux figures, la courbe 603 présente la même pente que la courbe 601.

La courbe 602 représente le taux d'erreur paquet sur ce même canal RSC, après codage selon le troisième mode de réalisation, donc avec un rendement de $(N-m-I)/N$=0.84. On remarque que les 1 symboles de parité/contrôles de parité ajoutés permettent de faire chuter de manière significative les erreurs/ effacements résiduels apparaissant dans le second état du canal.

**Revendications**

1. Méthode de codage correcteur d'erreurs dans un canal à évanouissement quasi-périodique, ladite méthode codant un bloc de $K$ symboles d'information en un bloc de $N$ symboles codés destinés à être transmis sur ledit canal, ledit évanouissement quasi-périodique se traduisant par un effacement d'au plus $m$ symboles consécutifs codés dudit bloc, ladite méthode utilisant un code $(N,K)$ défini par une matrice de contrôle de parité, $\mathbf{H}$, de taille $(N-K)\times N$, et étant **caractérisée en ce que** la taille $N$ du code vérifie $N = \bar{n}m$ et $N < \rho T$ où $\bar{n}$ est un nombre entier supérieur ou égal à 2, $\rho$ est le débit de transmission des symboles codés et $T$ étant la période entre évanouissements consécutifs du canal, ladite matrice de contrôle de parité étant obtenue par concaténation verticale d'une matrice supérieure $\mathbf{H_U}$ et d'une matrice inférieure, $\mathbf{H_L}$, ladite matrice supérieure $\mathbb{H}_{\mathrm{U}} = \left( \mathbb{T}_{\mathrm{m}}^{(1)} \middle| \mathbb{T}_{\mathrm{m}}^{(2)} \cdots \middle| \mathbb{T}_{\mathrm{m}}^{(\bar{n})} \right)$ étant obtenue par conca-ténation horizontale de $\bar{n}$ matrices triangulaires $\mathbb{T}_{\mathrm{m}}^{(n)}$, $n = 1,...,\bar{n}$ où les matrices $\mathbb{T}_{\mathrm{m}}^{(n)}$, de taille $m \times m$, sont toutes

triangulaires supérieures ou bien toutes triangulaires inférieures, et d'éléments diagonaux non nuls, ladite matrice inférieure étant constituée par la concaténation d'une première matrice élémentaire creuse, $\mathbf{H}_{\mathrm{L}}^{1}$, de taille $l{\times}K$, d'une seconde matrice élémentaire, $\mathbf{H}_{\mathrm{L}}^{2}$, triangulaire de taille $l \times l$, d'une troisième matrice élémentaire creuse, $\mathbf{H}_{\mathrm{L}}^{3}$, de taille $l{\times}(m{-}l)$, et d'une quatrième matrice élémentaire, $\mathbf{H}_{\mathrm{L}}^{4}$, triangulaire de taille $l{\times}l$ et de diagonale nulle, les matrices $\mathbf{H}_{\mathrm{L}}^{2}$ et $\mathbf{H}_{\mathrm{L}}^{4}$ étant de même nature, inférieure ou supérieure, que les matrices triangulaires $\mathbf{T}_{\mathrm{m}}^{(\mathrm{n})}$, $n$ =1,..., $\overline{n}$, la matrice de contrôle de parité étant définie à une permutation près de ses lignes, et l'ordre des colonnes de la matrice de contrôle de parité correspondant à l'ordre de transmission des symboles codés sur ledit canal.

2. Méthode de codage selon la revendication 1, **caractérisée en ce que** les matrices triangulaires $\mathbf{T}_{\mathrm{m}}^{(\mathrm{n})}$, $n = 1,...,\overline{n}$ sont toutes identiques.

3. Méthode de codage selon la revendication 2, **caractérisée en ce que** les matrices triangulaires $\mathbf{T}_{\mathrm{m}}^{(\mathrm{n})}$, $n = 1,...,\overline{n}$ se réduisent à la matrice identité $\mathbf{I_m}$.

4. Méthode de codage selon la revendication 3, **caractérisée en ce que** la seconde matrice élémentaire, $\mathbf{H}_{\mathrm{L}}^{2}$, est une matrice triangulaire inférieure $\mathbf{T}_l$, et que la quatrième matrice élémentaire, $\mathbf{H}_{\mathrm{L}}^{4}$, n'a des éléments non nuls qu'au dessous de sa diagonale.

5. Méthode de codage selon la revendication 2, **caractérisée en ce que** la seconde matrice élémentaire, $\mathbf{H}_{\mathrm{L}}^{2}$, est une matrice triangulaire supérieure $\mathbf{T}_l$ de taille $l \times l$, et que la quatrième matrice élémentaire, $\mathbf{H}_{\mathrm{L}}^{4}$, de taille $l \times l$, n'a des éléments non nuls qu'au dessus de sa diagonale.

6. Méthode de codage selon l'une des revendications précédentes, **caractérisée en ce qu'**elle s'applique à la couche physique, lesdits symboles étant alors des bits.

7. Méthode de codage selon l'une des revendications 1 à 5, **caractérisée en ce qu'**elle s'applique à la couche liaison, lesdits symboles d'information étant des paquets de données de la couche physique.

8. Méthode de codage selon l'une des revendications 1 à 5, **caractérisée en ce qu'**elle s'applique à une couche de niveau $n > 2$ dans le protocole OSI, lesdits symboles d'informations étant des paquets formés par des données de la couche $n - 1$.

**Patentansprüche**

1. Codierverfahren zur Korrektur von Fehlern in einem Kanal mit quasi-periodischem Schwund, wobei das Verfahren einen Block von K Informationssymbolen in einen Block von *N* codierten Symbolen codiert, die dazu bestimmt sind, auf dem Kanal übertragen zu werden, wobei sich der quasi-periodische Schwund durch eine Auslöschung von höchstens *m* aufeinanderfolgenden codierten Symbolen des Blocks ausdrückt, wobei das Verfahren einen Code (*N, K*) verwendet, der durch eine Paritätskontrollmatrix *H* der Größe (*N - K*) $\times$ N definiert ist, und **dadurch gekennzeichnet ist, dass** die Größe *N* des Codes $N = \overline{n}m$ sowie $N < \rho T$ erfüllt, wobei $\overline{n}$ eine ganze Zahl größer oder gleich 2 ist, wobei $\rho$ die Übertragungsrate der codierten Symbole ist, und wobei T die Periode zwischen aufeinanderfolgenden Schwundereignissen des Kanals ist, wobei die Paritätskontrollmatrix erhalten wird durch vertikale Verknüpfung einer oberen Matrix $\boldsymbol{H_U}$ und einer unteren Matrix $\boldsymbol{H_L}$, wobei die obere Matrix $\boldsymbol{H_U} = \left( \boldsymbol{T_m^{(1)}} \middle| \boldsymbol{T_m^{(2)}} ... \middle| \boldsymbol{T_m^{(\overline{n})}} \right)$

erhalten wird durch horizontale Verknüpfung von $\overline{n}$ Dreiecksmatrizen $\boldsymbol{T_m^{(n)}}$, $n = 1,...,\overline{n}$, wobei die Matrizen $\boldsymbol{T_m^{(n)}}$ der Größe $m \times m$ alle obere Dreiecksmatrizen sind oder aber alle untere Dreiecksmatrizen sind, und mit diagonalen Elementen ungleich Null, wobei die untere Matrix gebildet ist durch die Verknüpfung einer ersten dünn besetzten Elementarmatrix $H_L^1$ der Größe $l \times K$, einer zweiten dreieckigen Elementarmatrix $H_L^2$ der Größe $l \times l$, einer dritten dünn besetzten Elementarmatrix $H_L^3$ der Größe $l \times (m - l)$ und einer vierten dreieckigen Elementarmatrix $H_L^4$ der Größe $l \times l$ und mit einer Null-Diagonalen, wobei die Matrizen $H_L^2$ und $H_L^4$ von gleicher unterer oder oberer Art sind wie die Dreiecksmatrizen $T_m^{(n)}$, , n = 1, ...,$\overline{n}$, wobei die Paritätskontrollmatrix bis auf eine Permutation ihrer Zeilen definiert ist, und die Reihenfolge der Spalten der Paritätskontrollmatrix der Reihenfolge der Übertragung der codierten Symbole auf dem Kanal entspricht.

2. Codierverfahren nach Anspruch 1, **dadurch gekennzeichnet, dass** die Dreiecksmatrizen $T_m^{(n)}$, n = 1, ..., $\overline{n}$ alle identisch sind.

3. Codierverfahren nach Anspruch 2, **dadurch gekennzeichnet, dass** die Dreiecksmatrizen $T_m^{(n)}$, n = 1, ..., $\overline{n}$ sich auf die Identitätsmatrix $I_m$ reduzieren.

4. Codierverfahren nach Anspruch 3, **dadurch gekennzeichnet, dass** die zweite Elementarmatrix $H_L^2$ eine untere Dreiecksmatrix $T_l$ ist, und dass die vierte Elementarmatrix $H_L^4$ nur unter ihrer Diagonalen Elemente ungleich Null hat.

5. Codierverfahren nach Anspruch 2, **dadurch gekennzeichnet, dass** die zweite Elementarmatrix $H_L^2$ eine obere Dreiecksmatrix $T_l$ der Größe $l \times l$ ist, und dass die vierte Elementarmatrix $H_L^4$ der Größe $l \times l$ nur über ihrer Diagonalen Elemente ungleich Null hat.

6. Codierverfahren nach einem der vorhergehenden Ansprüche, **dadurch gekennzeichnet, dass** es auf die physische Schicht angewandt wird, wobei die Symbole dann Bits sind.

7. Codierverfahren nach einem der Ansprüche 1 bis 5, **dadurch gekennzeichnet, dass** es auf die Verbindungsschicht angewandt wird, wobei die Informationssymbole Datenpakete der physischen Schicht sind.

8. Codierverfahren nach einem der Ansprüche 1 bis 5, **dadurch gekennzeichnet, dass** es auf eine Schicht mit Niveau $n > 2$ im OSI-Protokoll angewandt wird, wobei die Informationssymbole Pakete sind, die durch Daten der Schicht $n - 1$ gebildet sind.

**Claims**

1. Method of error correction coding in a channel with quasi-periodic fade, said method coding a block of $K$ information symbols in a block of $N$ coded symbols intended to be transmitted on said channel, said quasi-periodic fade resulting in an erasure of at the most $m$ consecutive coded symbols of said block, said method using a code ($N,K$) defined by a parity check matrix, **H**, of size ($N-K$)$\times N$, and being **characterised in that** the size $N$ of the code satisfies $N = \overline{n}m$ and $N < \rho T$ where $\overline{n}$ is an integer greater than or equal to 2, p is the transmission rate of the coded symbols and $T$ being the period between consecutive fades of the channel, said parity check matrix being obtained by vertical concatenation of an upper matrix **H$_U$** and of a lower matrix, **H$_L$**, said upper matrix $\mathbf{H_U} = \left( \mathbf{T_m^{(1)}} \middle| \mathbf{T_m^{(2)}} ... \middle| \mathbf{T_m^{(\overline{n})}} \right)$ being obtained by horizontal concatenation of $\overline{n}$ triangular matrices $\mathbf{T_m^{(n)}}$, $n=1,...,\overline{n}$ where the matrices $\mathbf{T_m^{(n)}}$, of size $m \times m$, are all upper triangular or instead all lower triangular, and have non-zero diagonal elements, said lower matrix being constituted of the concatenation of a first sparse elementary matrix, $\mathbf{H_L^1}$, , of size $l \times K$, of a second elementary matrix, $\mathbf{H_L^2}$ , triangular, of size $l \times l$, of a third sparse elementary matrix, $\mathbf{H_L^3}$, of size l$\times$($m$-$l$), and of a fourth elementary matrix, $\mathbf{H_L^4}$ , triangular, of size $l \times l$ and of zero diagonal, the matrices $\mathbf{H_L^2}$ and $\mathbf{H_L^4}$ being of same nature, lower or upper, as the triangular matrices $\mathbf{T}_m^{(n)}$, $n = 1,...,\bar{n}$, the parity check matrix being defined to within one permutation of its lines, and the order of the columns of the parity check matrix corresponding to the order of transmission of the coded symbols on said channel.

2. Coding method according to claim 1, **characterised in that** the triangular matrices $\mathbf{T}_m^{(n)}$, $n=1,...,\bar{n}$ are all identical.

3. Coding method according to claim 2, **characterised in that** the triangular matrices $\mathbf{T}_m^{(n)}$, $n = 1,...,\bar{n}$ are reduced to the identity matrix $\mathbf{I}_m$.

4. Coding method according to claim 3, **characterised in that** the second elementary matrix, $\mathbf{H}_L^2$, is a lower triangular matrix $\mathbf{T}_l$, and that the fourth elementary matrix, $\mathbf{H}_L^4$, only has non-zero elements below its diagonal.

5. Coding method according to claim 2, **characterised in that** the second elementary matrix, $\mathbf{H}_L^2$, is an upper triangular matrix $\mathbf{T}_l$ of size $l \times l$, and that the fourth elementary matrix, $\mathbf{H}_L^4$, of size $l \times l$, only has non-zero elements above its diagonal.

6. Coding method according to one of the preceding claims, **characterised in that** it applies to the physical layer, said symbols then being bits.

7. Coding method according to one of claims 1 to 5, **characterised in that** it applies to the link layer, said information symbols being data packets of the physical layer.

8. Coding method according to one of claims 1 to 5, **characterised in that** it applies to a layer of level $n > 2$ in the OSI protocol, said information symbols being packets formed by data of the layer $n$-1.

**Fig. 1**

Fig. 2A

Fig. 2B

Fig. 3

**Fig. 4**

**Fig. 5**

EP 2 722 992 B1

**Fig. 6A**

**Fig. 6B**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **G. SIASCIA et al.** Statistical characterization of the railroad satellite channel at Ku-band. *Proceedings of the International Workshop of COST actions 272 and 280,* Mai 2003
- **B. MATUZ et al.** Link layer coding for DVB-S2 interactive satellite service to trains. *Vehicular Technology Conference,* 11 Mai 2008, 2922-2926
- **S. CIONI et al.** Advanced fade countermeasures for DVB-S2 systems in railway scenarios. *EURASIP Journal on Wireless communications and networking,* 2007, 1-17